Europäisches Patentamt

European Patent Office

Office européen des brevets

(11) Publication number: **0 092 321**
A1

## (12) EUROPEAN PATENT APPLICATION

(21) Application number: 83301685.0

(22) Date of filing: 25.03.83

(51) Int. Cl.³: **H 01 B 13/16,** H 01 G 1/02, H 01 G 13/00, H 01 L 49/02, H 05 K 3/28

(30) Priority: 06.04.82 GB 8210134

(43) Date of publication of application: 26.10.83 Bulletin 83/43

(84) Designated Contracting States: **DE FR GB IT**

(71) Applicant: **STANDARD TELEPHONES AND CABLES PUBLIC LIMITED COMPANY, 190 Strand, London, WC2R 1DU (GB)**

(72) Inventor: **Sterling, Henley Frank, 18 Springfields, Great Dunmow Essex (GB)**
Inventor: **Alexander, John Henry, 23 Blackbushe, Bishop's Stortford Hertfordshire (GB)**
Inventor: **Bush, Eric Langley, 5 Perryfield, Matching Green Nr.. Harlow Essex (GB)**

(74) Representative: **Capsey, Sydney Ross, Standard Telephones and Cables Patent Department Edinburgh Way, Harlow Essex CM20 2SH (GB)**

(54) **Insulating coatings.**

(57) Exposed conductive surfaces of an electrical component are insulated by electrodeposition of an insulating material followed by a curing stage to form an uniform impervious coating. The coating may provide the sole coating on the component or it may provide a tie coating for subsequent encapsulation.

H.F. Sterling-E.L. Bush-
J.H. Alexander 85-26-19

## INSULATING COATINGS

This invention relates to the provision of
protective surface coatings on electrical components or
parts thereof and to electrical components provided with
such coatings.

There are numerous applications wherein it is
necessary to provide a protective coating on a component
or part thereof.  This coating may be required to
electrically insulate conductive parts such as lead wires
and terminations or to provide protection from the
atmosphere, in particular with regard to humidity
protection.  At present there are various techniques that
may be employed including dip-coating, fluidized bed
coating, injection moulding, transfer moulding and
spraying of plastic materials.  These materials are
generally insulating and may contain pigments and other
additives to confer specific properties to the coating,
such as flame retardancy.

Although the current techniques are widely
accepted and are simple to operate, they suffer a number
of disadvantages.  To avoid the formation of pin-holes
the coating is usually unduly thick.  The bond between
lead wires and the encapsulant is often the most
vulnerable area through which moisture may penetrate and
reach the component.  In most cases extreme cleanliness
and care are required to achieve a hermetic seal.  Many
of the methods in use are not effective in providing a
complete bond to every part of the component so that
bubbles or voids are formed.  One solution is to employ a tie-coat and the main encapsulation, and the tie coats -themselves must be chosen to be mutually compatible with the component surfaces and the encapsulant.

A further disadvantage of thick encapsulant layers is the associated fire risk should a short circuit occur in the component. This is particularly the case with multilayer ceramic capacitors which are encapsulated in plastic material. In the event of a capacitor failure, a large current can flow in some circuits. This has resulted in carbonisation of the plastic material, and further increased current flow through this carbon path. Adjacent components and circuit boards are then at risk of fire. Flame retardant formulations are not entirely satisfactory particularly with regard to carbonization, and can also lead to increased costs. An alternative approach to the use of flame retardant is to reduce the thickness and coverage of the protective coating to a level which eliminates the fire risk but nevertheless still provides the protection. Under these conditions, if an overload situation arises then overheating of the ceramic capacitor causes the solder to melt and the capacitor is disconnected.

Furthermore, the present techniques are not ideally suited to the surface protection of delicate components. Thus, by way of example, when multilayer ceramic capacitors are manufactured the tolerance of capacitance as manufactured is a function of the number of layers and the dielectric spacing and may typically be 20%. In some applications it is desirable to have a much closer tolerance product (say $\pm$ 5% or $\pm$ 1%), and therefore an approach adopted by some manufacturers involves an air abrasion technique to remove a portion of the active area of the capacitor. The process, however, leaves closely spaced adjacent electrodes of opposite polarity exposed and unprotected. It is normal to back-fill the exposed area with some form of plastic encapsulant, but unless there is a very good bond to the ceramic surface and the exposed electrodes there is a risk of producing a short circuit path even for a fully encapsulated unit.  In the case of chip capacitors the situation is even more critical.  Although multilayer ceramic capacitors are particularly vulnerable, the problem of repairing any damage resulting from the above trimming process applies, in some degree, to other components.

Certain components are particularly sensitive to moisture and even when encapsulated by the generally accepted methods, it may be difficult to achieve the required humidity protection.  Mica capacitors may be considered by way of example.  Mica capacitors are manufactured by stacking and firing mica sheets which have previously been silver coated each with an electrode pattern.  By registration of these alternative electrode layers, connections are brought out at the edges of opposite ends of the stack.  Along the side edges of the mica stack, the silver electrodes do not reach the surface but are set back from the edge.  In comparison with multilayer ceramic capacitors in which the electrodes are actually buried in the fired dielectric, the silver electrodes in the mica capacitor are simply laminated and effectively exposed to the outer surface albeit by a tenuous path.  It is this tenuous track which, when subjected to condensation in humid conditions, can provide a leakage path between adjacent electrodes.  The encapsulation only covers the outer surface of the mica and does not normally penetrate into the laminated interstices of the stack.  However, within the stack itself, these tenuous tracks still exist.  As moisture permeates into the encapsulant during long term damp heat testing, the interior of the capacitor approaches and in time reaches the same humidity level as the test environment.  To insulate the adjacent electrodes from this leackage path, it is necessary to "seal" the edge surface of these silver electrodes. Such a technique can be termed "deactivation".

The object of the present invention is to minimise or overcome the disadvantages inherent in prior art techniques.

According to one aspect of the invention there is provided a process for coating an exposed conductive surface of an electrical component, said process comprising electrodepositing insulating material on the exposed surface, and curing said coating to form a coherent impervious surface film.

According to another aspect of the invention there is provided a process for providing an insulating encapsulant coating on an electrical component having a conductive surface, characterised in that the encapsulant coating is applied to a tie coating on the component surface, and that the tie coating comprises a cured layer of an electrodeposited insulating material.

According to a further aspect of the invention there is provided a process for capacitance adjustment of a multilayer ceramic capacitor, the process including removing a portion of the active region of the capacitor to provide a desired capacitance value and thereby exposing positive and negative electrode edges, coating the exposed electrode edges with an electrodeposited layer of insulating material, and curing the layer to form a coherent surface film.

The application of paint to metal by a process of electrodeposition has gained widespread acceptance during the past ten years. The modern development of water-borne stoving paint resins and the application of Faraday principles have given rise to a uniquely satisfactory method for the finishing of metal fabrications.

In the application of paint by electrodeposition the article to be coated is submerged in a bath of suitable water-borne paint and connected to one pole of a direct current source. An electrode of the opposite polarity is also present in the paint container which may itself act as the counter-electrode. A current is passed for a short period (typically one to two minutes) and deposition of the paint film of the component results from the electrochemical process and subsequent chemical reactions which occur at the interface with the paint. When deposition is complete, the article is removed from the bath and rinsed in water. The article is then heat-treated in the normal way to cure the resin film.

In accordance with Faraday's laws, the thickness of the paint obtained is related to the quantity of electricity passed and not to either the concentration and rheology of the medium, or the shape and deposition of the article as is the case with conventional dip coating.

In common with other similar water-borne painting processes, fire and toxic hazards are negligible. Good throwing-power and uniform thickness of deposition are obtained because, as deposition proceeds and an insulating film is built up, the balance of current moves from the more accessible regions of the article being coated, to those less accessible regions yet to be coated with an insulating paint film.

The loss of paint material which occurs on rinsing can be kept small because dispersions are typically about 10% solids in water. Viscosity is similar to that of water, so that the tank contents may be easily handled. Paint is only deposited on to those metal parts of the article which are actually connected into the electrical circuit. Other immersed metallic (or insulating) portions of the component are ignored by the paint medium. This means that electrically isolated metal wires or fittings may be individually treated in different colours, or with media having different properties. We have found that similar techniques may be employed in the application of insulating coatings to electrical components.

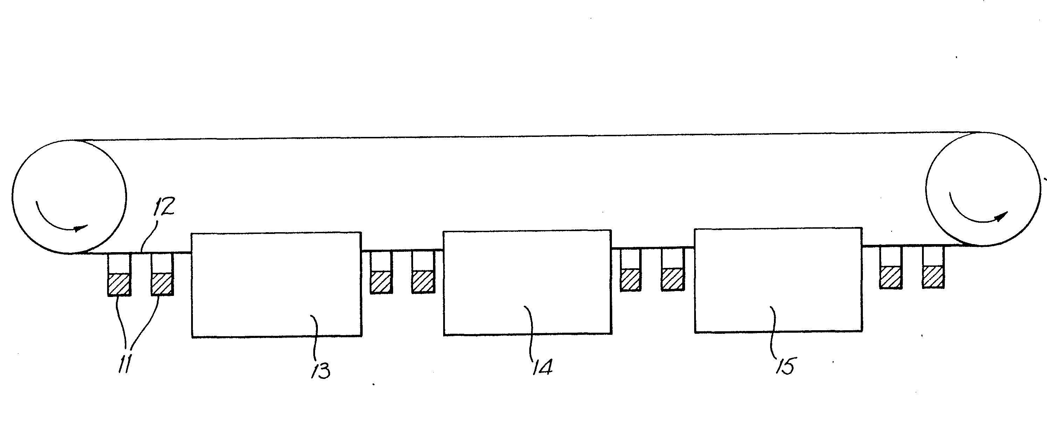

An embodiment of the invention will now be described with reference to the accompanying drawing in which the single Figure is a schematic diagram of an electrocoating apparatus.

Referring to the drawing, piece parts or components 11 to be electrocoated are mounted on a conveyor 12 whereby they are carried through a washing station 13 and then through a tank 14 containing an electro-coating material. An electric potential, typically 100 to 200 volts, is applied between the components 11 and the tank 14 causing deposition of the electrocoating material on to all exposed conductive regions of the surface of each component 11.

After coating is effected and after washing, the components 11 are carried through a drying station 15 where the deposited material is cured to form a uniform impervious surface coating. Typically we employ oven curing but any other suitable techniques, for example the use of ultraviolet light on ionising radiation, may of course be employed.

It will be appreciated that the process is self-limiting as only exposed conductive regions will be coated, and the deposition ceases as soon as a predetermined coating thickness has been obtained. These features inherent in the process ensure that the deposit is uniform in thickness and is free from pin-holes.

A variety of insulating coating materials may be employed in the process suitable materials include but are in no way limited to resins based on the epoxy system, perhaps cross-linked with melamine or phenol. There are many resin systems available and known to the art which may be suitable for particular applications. Advantageously the material has a low flammability.

The electrodeposited insulating coating may provide a tie coating for a subsequent encapsulating coating, or in some applications it may provide the sole coating on the component.

A particularly advantageous application of the process is the insulation of multilayer ceramic capacitors following adjustment of capacitance by air abrasion. The effect of air abrasion is to remove a portion of the active region of the capacitor and this, of course, leaves electrodes of opposite polarity exposed at the abrasive surface. This is clearly undesirable as it can lead to electrode damage or interelectrode shorts. The surface is particularly vulnerable to traces of moisture. These disadvantages may be overcome by electrocoating the exposed electrode ends with an insulating material. To effect such coating the capacitor terminals are usually shorted together, the device is placed in an electrocoating bath and a potential is applied to the exposed electrodes via the terminals. Deposition takes place on the exposed electrodes to a desired thickness. When the desired coating thickness has been reached the capacitor is removed from the bath and the coating is cured prior to further processing. In some cases, it may be advantageous to treat each of the two electrode systems separately.

Various modifications of the process described herein may be employed. For example a printed circuit board assembly or a film circuit may be subjected to the electrocoating process to protect exposed conductive regions. Such a treatment reduces the incidence of tracking when the circuit is exposed to a humid or corrosive atmosphere. The process may also be applied to the treatment of a wide variety of components including e.g. integrated circuits, connectors and device packages. Further modifications will no doubt be apparent to those skilled in the art.

- 8 -                    0092321

CLAIMS:-

1.      A process for coating an exposed conductive portion of an electrical component, said process comprising electrodepositing insulating material on the exposed portion, and curing said coating to form a coherent impervious surface film.

2.      A process for protecting an electrical component from the effects of humidity by electrocoating adjacent conductive regions of the component with an insulating material, thereby reducing ionic migration and electronic conductivity between said regions.

3.      A process as claimed in Claim 1 or 2, characterised in that said component is a multilayer ceramic capacitor.

4.      A process as claimed in Claim 1 or 2, characterised in that said component is a mica capacitor.

5.      A process as claimed in Claim 1, 2, 3 or 4, characterised in that the component is part of a film circuit, printed circuit of similar system and where the component is afforded protection by said process.

6.      A process as claimed in any one of Claims 1 to 5, characterised in that the deposited coating acts as a tie-coat between metallic parts of the component and an encapsulant.

7.      A process as claimed in any one of Claims 1 to 5, characterised in that the coating is the sole coating on the component.

8.      A process as claimed in Claim 7, characterised in that said coating is substantially a non-combustible.

9.      A process as claimed in any one of Claims 1 to 8, characterised in that the insulating material is an epoxy resin.

10.     A process as claimed in Claim 9, characterised in that the resin material is cross-linked.

11.     A process as claimed in any one of Claims 1 to 10, characterised in that said deposited layer is cured by heat.

12. A process as claimed in any one of Claims 1 to 10, characterised in that said deposited layer is cured by ultraviolet light or ionising radiation.

13. A process for capacitance adjustment of a multilayer ceramic capacitor, the process including removing a portion of the active region of the capacitor to provide a desired capacitance value and thereby exposing the electrode edges, coating the exposed electrode edges with an electrodeposited layer of a coherent insulating material, and curing the layer.

14. A process as claimed in Claim 13, characterised in that the portion of the active region is removed by air abrasion.

15. A process as claimed in Claim 13 or 14, characterised in that the capacitor is provided with a subsequent encapsulating coating.

16. A process for providing an insulating encapsulant coating on an electrical component having a conductive surface, characterised in that the encapsulant coating is applied to a tie coating on the component surface, and that the tie coating comprises a cured layer of an electrodeposited insulating material.

17. A multilayer capacitor treated by a process as claimed in any one of claims 13 to 16.

0092321

H.F. STERLING 85-26-19

**European Patent Office**

**EUROPEAN SEARCH REPORT**

Application number

| DOCUMENTS CONSIDERED TO BE RELEVANT | | | EP 83301685.0 |
|---|---|---|---|
| Category | Citation of document with indication, where appropriate, of relevant passages | Relevant to claim | CLASSIFICATION OF THE APPLICATION (Int. Cl. 3) |
| X | FR - A - 2 210 042 (GENERAL ELEC-TRIC) <br> * Page 1, lines 1-11; page 3, lines 3-15; examples * | 1,2,6, 10,11, 16, | H 01 B 13/16 <br> H 01 G 1/02 <br> H 01 G 13/00 <br> H 01 L 49/02 <br> H 05 K 3/28 |
| Y | * Page 1, lines 1-11; page 3, lines 3-15; examples * | 5 | |
| Y | DER ELEKTRONIKER, 1970, no. 2, Aareau, CH, <br><br> K. OSSWALD, "Dickfilmtechnik, Technologie und Anwendung" pages 49-56 <br><br> * Page 53, left hand column * | 5 | |
| X | GB - A - 655 763 (SPRAGUE ELEC-TRIC) <br> * Page 2, lines 13-67 * | 1,7,8, 11 | |
| | | | **TECHNICAL FIELDS SEARCHED (Int. Cl. 3)** |
| | DE - A1 - 2 131 894 (WESTERMANN) | | H 01 B 13/00 <br> H 01 G |
| X | * Claim 1 * | 1,9-11, | H 01 L |
| Y | * Claim 1 * | 3,4,12, 13-15, 17 | H 02 K 15/00 <br> H 05 K 3/00 |
| Y | DE - B2 - 2 811 898 (STETTNER) <br> * Column 4, lines 21-23; column 6, lines 18-22 * | 3 | C 25 D 13/00 |
| Y | CH - A - 493 916 (INT. STANDARD ELECTRIC) <br> * Claim * | 4 | |

The present search report has been drawn up for all claims

| Place of search | Date of completion of the search | Examiner |
|---|---|---|
| VIENNA | 08-07-1983 | KUTZELNIGG |

**European Patent Office**

## EUROPEAN SEARCH REPORT

EP 83301685.0

| | DOCUMENTS CONSIDERED TO BE RELEVANT | | CLASSIFICATION OF THE APPLICATION (Int. Cl.²) |
|---|---|---|---|
| Category | Citation of document with indication, where appropriate, of relevant passages | Relevant to claim | |
| Y | DE - A1 - 2 819 910 (BOSCH)<br>* Claim 4 *<br>-- | 12 | |
| Y | DE - A1 - 2 754 789 (CAUWENBERGHE)<br>* Claim 1 *<br>-- | 12 | |
| Y | DE - B1 - 1 564 559 (SIEMENS)<br>* Claims *<br>-- | 13-15, 17 | |
| X | GB - A - 1 006 174 (I.B.M.)<br>* Claims 1-3 *<br>---- | 1 | **TECHNICAL FIELDS SEARCHED (Int. Cl.²)** |

EPO Form 1503.2   06.78